(19) Europäisches Patentamt / European Patent Office / Office européen des brevets

(11) **EP 2 524 763 B1**

(12) **EUROPEAN PATENT SPECIFICATION**

(45) Date of publication and mention
of the grant of the patent:
**05.12.2018 Bulletin 2018/49**

(51) Int Cl.:
**B23K 35/36** (2006.01)  **B23K 35/362** (2006.01)
**C22C 12/00** (2006.01)  **C22C 13/00** (2006.01)
**H05K 3/34** (2006.01)

(21) Application number: **10835925.8**

(22) Date of filing: **06.12.2010**

(86) International application number:
**PCT/JP2010/071807**

(87) International publication number:
**WO 2011/071005 (16.06.2011 Gazette 2011/24)**

(54) **SOLDER PASTE**

LÖTPASTE

PÂTE À BRASER

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **08.12.2009 JP 2009278209**

(43) Date of publication of application:
**21.11.2012 Bulletin 2012/47**

(73) Proprietors:
• **Arakawa Chemical Industries, Ltd.
Osaka-shi
Osaka 541-0046 (JP)**
• **TOYOTA JIDOSHA KABUSHIKI KAISHA
Toyota-shi, Aichi-ken, 471-8571 (JP)**
• **Denso Corporation
Kariya-city
Aichi 448-8661 (JP)**
• **DENSO TEN Limited
Hyogu-ku,
Kobe-shi
Hyogo 652-8510 (JP)**
• **Koki Company Limited
Tokyo 120-0026 (JP)**
• **Harima Chemicals, Inc.
Hyogo 675-0019 (JP)**

(72) Inventors:
• **IWAMURA, Eiji
Osaka-shi
Osaka 538-0053 (JP)**
• **GOTOH, Kazushi
Osaka-shi
Osaka 538-0053 (JP)**
• **ISHIGA, Fumio
Osaka-shi
Osaka 538-0053 (JP)**
• **YOSHIOKA, Takayasu
Toyota-shi
Aichi 471-8571 (JP)**
• **UTSUNO, Masayoshi
Toyota-shi
Aichi 471-8571 (JP)**
• **NAKAMURA, Atsuo
Toyota-shi
Aichi 471-8571 (JP)**
• **OKOCHI, Teruo
Toyota-shi
Aichi 471-8571 (JP)**
• **SANJI, Masaki
Kariya-city
Aichi 448-8661 (JP)**
• **SUKEKAWA, Takuji
Kariya-city
Aichi 448-8661 (JP)**
• **IKEDO, Kenshi
Kobe-shi
Hyogo 652-8510 (JP)**
• **ANDOH, Yoshiyuki
Kobe-shi
Hyogo 652-8510 (JP)**
• **SHIRAI, Takeshi
Tokyo 120-0026 (JP)**
• **MORI, Kimiaki
Tokyo 120-0026 (JP)**

- **WADA, Rie**
  **Tokyo 120-0026 (JP)**
- **NAKANISHI, Kensuke**
  **Kakogawa-shi**
  **Hyogo 675-0019 (JP)**
- **AIHARA, Masami**
  **Kakogawa-shi**
  **Hyogo 675-0019 (JP)**
- **KUMAMOTO, Seishi**
  **Kakogawa-shi**
  **Hyogo 675-0019 (JP)**

(74) Representative: **Wächter, Jochen**
  **Kroher-Strobel**
  **Rechts- und Patentanwälte PartmbB**
  **Bavariaring 20**
  **80336 München (DE)**

(56) References cited:
  **JP-A- 1 228 696          JP-A- 7 075 894**
  **JP-A- 9 253 884          JP-A- 62 168 695**
  **JP-A- 2000 288 772       JP-A- 2002 336 993**
  **US-A- 5 443 659          US-A- 5 907 007**

**Description**

TECHNICAL FIELD

The present invention relates to a solder paste.

BACKGROUND ART

Conventionally, various solder pastes have been used for solder bonding of electronic circuit components and the like. Particularly, a flux included in a solder paste is used as a material for removing a metal oxide on the surface of solder and the surface of a circuit board and preventing reoxidation of a metal during soldering. In addition, the flux plays an important role for reducing the surface tension of solder and performing soldering in good condition.

Incidentally, attempts have been conventionally made to improve the reliability and soldering ability by adding an organic acid and the like in combination to a flux for a solder paste (hereinafter referred to simply as flux). However, there has not been found a flux that adequately meets market needs for the slumping resistance which, in recent years, has gradually received attention in association with miniaturization of electronic circuit components and the like. A flux poor in slumping resistance may cause frequent occurrence of solder balls in a chip component. Therefore, if the solder ball drops, the solder ball enters between leads of components with pitches narrowed in association with miniaturization of components, thus raising the possibility of causing a short-circuit failure. In addition, the aforementioned market needs can be particularly strict with on-vehicle electronic components.

For improvement of the above-mentioned slumping resistance, in other words "shear drop" by heating, a number of proposals have been made so far. Specifically, those include, for example, the following methods.

a) Method of incorporating a polyethylene glycol polypropylene glycol-polyethylene glycol block polymer into a solder paste composition containing a solder powder, a rosin resin, an activator and a solvent (see Patent Document 1).
b) Method of adding a fluorine compound such as a fluororesin compound or a fluorosurfactant in a flux of a solder paste in an amount of 0.05 to 10% by weight (see Patent Document 2).
c) Method of preparing a solder paste by mixing a solder powder comprising a spherical powder and amorphous powders of various shapes with a pasty flux, wherein the amorphous powders are mixed in an amount of 10 to 50% by weight based on the total solder powder (see Patent Document 3).

PRIOR ART DOCUMENTS

PATENT DOCUMENTS

Patent Document 1: Japanese Unexamined Patent Publication No. 2002-336993
Patent Document 2: Japanese Unexamined Patent Publication No. H06-7989
Patent Document 3: Japanese Unexamined Patent Publication No. H07-88675
Patent Document 4: Japanese Unexamined Patent Publication No. H09-253884

SUMMARY OF THE INVENTION

PROBLEMS TO BE SOLVED BY THE INVENTION

As described above, it is very difficult to develop a flux and a solder paste well applicable to electronic circuit components, miniaturization of which has been significantly progressed. For example, employment of methods (a) and (b) described in Patent Documents 1 and 2 mentioned above cannot provide adequate reliability because when a low-volatile polar substance is added, it remains even after solder is melted. Employment of the method (c) described in Patent Document 3 mentioned above leads to not only a reduction in flowability of a solder paste but also a degradation in transfer printing characteristics of details because amorphous powders are added.

In addition, for a flux of a solder paste composition that has been used so far, an organic acid, particularly a dibasic acid with a relatively low molecular weight (for example a molecular weight of 250 or less) from the viewpoint of activation power has been used as an activator (see Patent Document 4). However, for a lead-free solder paste which has been used in recent years, strong activation power is required as compared to a conventional tin-lead alloy-based solder paste, and therefore the above-mentioned dibasic acid must be used in a large amount. Thus, an organic acid metal salt produced by reaction of the dibasic acid with a metal oxide in soldering cannot be fully dissolved in a flux residue, resulting in spotted deposition of the organic acid metal salt on a substrate. The deposit becomes a cause of corrosion or insulation deterioration as the organic acid is easily dissociated by water.

Thus contemplated is a method for coping with the problem by reducing the content of a dibasic acid contained in the flux of the solder paste composition or replacing the dibasic acid with a monobasic acid. However, when such a method is carried out, activation power is reduced even though an improvement is provided in the respect of deposition of a metal salt. As a result, a soldering failure frequently occurs in association with the reduction in activation power.

SOLUTIONS TO THE PROBLEMS

The present invention solves the above technical problems to significantly contribute to realization of a solder paste well applicable to electronic circuit components, miniaturization of which has been significantly progressed in recent years, and practical application thereof. The inventors have conducted vigorous studies for obtaining a solder paste that realizes high reliability and good soldering ability with attention given particularly to improvement of the functionality of an activator and a base resin contained in a flux for a solder paste and a solder paste. As a result, it has been found that employment of a solder paste containing an activator comprising multiple kinds of dibasic acids, which molecular weight are in a specified range and one kind of monobasic acid and a specific resin additive leads to maintenance of high reliability and excellent soldering ability and further to an improvement in slumping resistance. In addition, the inventors have found that the solder paste also takes into consideration impacts on environment without increasing production costs. The present invention has been created by way of such a viewpoint and circumstances.

The solder paste of the present invention includes within a flux an activator that has a dibasic acid with a molecular weight of 250 or less, a monobasic acid with a molecular weight of 150 or greater and 300 or less, and a dibasic acid with a molecular weight of 300 or greater and 600 or less; and at least one resin additive selected from the group consisting of polyethylenes having a density of 942 kg/m3 or greater and polypropylenes, wherein the solder paste has the resin additive in an amount of 4% by weight or greater and 12% by weight or less when the total amount of the flux is taken as 100% by weight. In addition, the solder paste has a viscosity at 80°C of 400 Pa●s or greater. Furthermore, the dibasic acid with a molecular weight of 250 or less is selected from the group of malonic acid, succinic acid, glutaric acid, adipic acid, suberic acid, sebacic acid, phthalic acid, hexahydrophthalic acid, aminosuccinic acid and diphenic acid; the monobasic acid with a molecular weight of 150 or greater and 300 or less is selected from the group of decanoic acid, stearic acid, oleic acid, anisic acid, benzoylbenzoic acid, dichlorobenzoic acid, dibromosalicylic acid, diphenyl acetic acid and cuminic acid, and the dibasic acid with a molecular weight of 300 or greater and 600 or less is selected from the group of an esterification product of diethylene glycol and succinic anhydride, a (meth)acrylic acid adduct of an unsaturated fatty acid and a dimer of an unsaturated fatty acid.

The solder paste can realize high reliability and excellent soldering ability by having the activator described above. Inclusion of at least one selected from the group consisting of high-density polyethylenes and polypropylenes contributes to an increase in viscosity of the solder paste at high temperature (80°C) conditions, so that the slumping resistance can be improved. In other words, "shear drop" by heating can be suppressed.

EFFECTS OF THE INVENTION

According to one solder paste of the present invention, the slumping resistance is improved. In other words, "shear drop" by heating can be suppressed.

BRIEF DESCRIPTION OF THE DRAWINGS

Fig. 1 is a photomicrograph of a flux in one embodiment of the present invention.
Fig. 2 is a graph showing a particle size distribution of high-density polyethylenes in Example 1 of the present invention.

MODES FOR CARRYING OUT THE INVENTION

An embodiment of the present invention will now be described.

As described above, the flux for a solder paste of this embodiment has an activator having a dibasic acid with a molecular weight of 250 or less, a monobasic acid with a molecular weight of 150 or greater and 300 or less and a dibasic acid with a molecular weight of 300 or greater and 600 or less. The flux for a solder paste of this embodiment also includes at least one resin additive selected from the group consisting of high-density polyethylenes and polypropylenes, and the amount of the resin additive to be added is 4% by weight or greater and 12% by weight or less when the total amount of the flux is taken as 100% by weight. In addition, the solder paste of this embodiment has a viscosity of 400 Pa●s or greater at 80°C. The polyethylene in the present invention has a density of 942 kg/m$^3$ or greater as defined in JIS K6922-1:1997.

Here, the activator described above can contribute to an improvement in slumping resistance, in other words suppression of "shear drop" by heating. As described above, any one or both of the high-density polyethylene and the polypropylene contribute to an increase in viscosity of the flux and solder paste under, for example, a temperature of 80°C at which a common flux for a solder paste starts to soften. Therefore, for example, "shear drop" by heating can be suppressed in a process commonly referred to as reflow in which a base electrode and an electronic component are soldered together by heating/melting solder. Thus, such a solder paste can be also applied to electronic circuit components, miniaturization of which has been significantly progressed, as the above-mentioned occurrence of a ball can be suppressed.

As a dibasic acid with a molecular weight of 250 or less, a dibasic acid with a molecular weight of 90 or greater is preferable. A representative example of the dibasic acid with a molecular weight of 250 or less can be selected from the group of malonic acid, succinic acid, glutaric acid, adipic acid, suberic acid, sebacic acid, phthalic acid, hexahydrophthalic acid, aminosuccinic acid and diphenic acid. A representative example of the monobasic acid with a molecular weight of 150 or greater and 300 or less can be selected from the group of decanoic acid, stearic acid, oleic acid, anisic acid, benzoylbenzoic acid, dichlorobenzoic acid, dibromosalicylic acid, diphenyl acetic acid and cuminic acid. Further, a representative example of the dibasic acid with a molecular weight of 300 or greater and 600or less can be selected from the group of Model Number: SL-20 (manufactured by Okamura Oil Mill Co., Ltd.), an esterification product of diethylene glycol and succinic anhydride, a (meth)acrylic acid adduct of an unsaturated fatty acid and a dimer of an unsaturated fatty acid. As an example of other activator that can be used, a hydrohalic acid salt of ethylamine, propylamine, diethylamine, triethylamine, diphenylguanidine, ethylenediamine, aniline or the like, lactic acid or citric acid.

The amounts of the above-mentioned dibasic acid with a molecular weight of 250 or less, monobasic acid with a molecular weight of 150 or greater and 300 or less and dibasic acid with a molecular weight of 300 or greater and 600 or less to be used are not particularly limited. However, it is preferable to have about 100 parts by weight or greater and 500 parts by weight or less of monobasic acid with a molecular weight of 150 or greater and 300 or less based on 100 parts by weight of the dibasic acid with a molecular weight of 250 or less from the viewpoint of maintenance of soldering ability and reliability. From the aforementioned viewpoint, it is further preferable to have about 150 parts by weight or greater and 350 parts by weight or less of monobasic acid with a molecular weight of 150 or greater and 300 or less, in particular, based on 100 parts by weight of the dibasic acid with a molecular weight of 250 or less. On the other hand, it is preferable from the aforementioned viewpoint to have about 80 parts by weight or greater and 400 parts by weight or less of dibasic acid with a molecular weight of 300 or greater and 600 or less based on 100 parts by weight of the dibasic acid with a molecular weight of 250 or less. From the aforementioned viewpoint, it is further preferable to have about 80 by weight or greater and 300 parts by weight or less of dibasic acid with a molecular weight of 300 or greater and 600 or less based on 100 parts by weight of the dibasic acid with a molecular weight of 250 or less.

The amount of any one or both of the high-density polyethylene and the polypropylene to be used may be 4% by weight or greater and 12% by weight or less when the total amount of flux is taken as 100% by weight. However, it is further preferable that any one or both of the high-density polyethylene and the polypropylene be present in an amount of about 5 parts by weight or greater and 9 parts by weight or less based on 100 parts by weight of the flux from the viewpoints of prevention of slump by heating and ease of adjustment of the viscosity of the solder paste.

Here, it is one preferred aspect that the high-density polyethylene for use in this embodiment meets at least one of the following requirements a) to d) for the particle size, particle size distribution or shape of particulate high-density polyethylenes within the flux for a solder paste.

a) The high-density polyethylenes have an average of the longest particle sizes of 0.001 μm or greater and 50 μm or less.
b) The number of high-density polyethylenes with a longest particle size of 60 μm or less within a randomly selected field of 1.5 mm x 1.1 mm in the flux for a solder paste is 90% or greater of the total number of the high-density polyethylenes when observed at a 200x magnification by a light microscope.
c) The number of high-density polyethylenes with a longest particle size of 100 μm or greater within a randomly selected field of 3.1 mm x 2.3 mm in the flux for a solder paste is 1% or less of the total number of the high-density polyethylenes when observed at a 100x magnification by a light microscope.
d) The high-density polyethylene has a polyhedron shape.

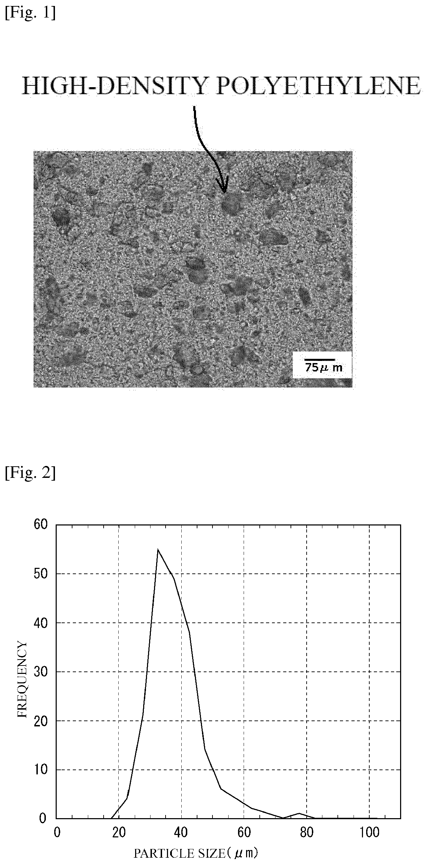

By meeting the requirements, for example, accuracy is increased with which the high-density polyethylene within the flux is placed on a miniaturized electrode or the like, and therefore applicability to electronic circuit components and the like is further improved. Fig. 1 is a photomicrograph of a flux constituting a part of the solder paste of this embodiment. As shown in Fig. 1, high-density polyethylenes having multiple particle sizes within the aforementioned range are observed within the flux. In the case of the flux shown in Fig. 1, scrapes greater than 50 $\mu$m are not observed according to grain gage measurements, and therefore the high-density polyethylenes have a longest size of about 50 $\mu$m or less. Many high-density polyethylenes have a polyhedron shape. It is more preferable to meet two or more of the requirements a) to d) at the same time, and it is further preferable to meet all the requirements at the same time.

Incidentally, it is one preferred aspect that the high-density polyethylene has a molar weight of viscosity of 1500 or greater and 4500 or less. If this range of molar weight of viscosity is met, the effect of suppression of "shear drop" during heating is further improved.

It is another preferred aspect that the high-density polyethylene has a melting point of 110°C or higher and 130°C or lower. If this range of melting point is met, the effect of suppression of "shear drop" during heating is further improved.

It is another preferred aspect that the high-density polyethylene has an acid value of 1 or less. If this range of acid value is met, reduction of insulation reliability by addition of the high-density polyethylene can be prevented.

In addition, it is another preferred aspect that the high-density polyethylene has a glass transition temperature of -50°C or lower. If this range of glass transition temperature is met, deterioration of the clacking resistance of flux residues, which is required particularly for a paste for an on-vehicle electronic component, can be suppressed.

Next, it is one preferred aspect that the polypropylene for use in this embodiment meets at least one of requirements a) to d) for the particle size, particle size distribution or shape of particulate polypropylenes within the flux for a solder paste.

a) The polypropylene has an average of the longest particle sizes of 0.001 $\mu$m or greater and 50 $\mu$m or less.
b) The number of polypropylene with a longest particle size of 60 $\mu$m or less within a randomly selected field of 1.5 mm x 1.1 mm in the flux for a solder paste is 90% or greater of the total number of the polypropylene when observed at a 200x magnification by a light microscope.
c) The number of polypropylene with a longest particle size of 100 $\mu$m or greater within a randomly selected field of 3.1 mm x 2.3 mm in the flux for a solder paste is 1% or less of the total number of the polypropylene when observed at a 100x magnification by a light microscope.
d) The polypropylene has a polyhedron shape.

By meeting the requirements, for example, accuracy is increased with which the polypropylene within the flux is placed on a miniaturized electrode or the like, and therefore applicability to electronic circuit components and the like is further improved. It is more preferable to meet two or more of the requirements a) to d) at the same time, and it is further preferable to meet all the requirements at the same time.

Here, it is one preferred aspect that the polypropylene has a molar weight of viscosity of 5000 or greater and 20000 or less. If this range of molar weight of viscosity is met, the effect of suppression of "shear drop" during heating is further improved.

It is another preferred aspect that the polypropylene has a melting point of 130°C or higher and 160°C or lower. If this range of melting point is met, the effect of suppression of "shear drop" during heating is further improved.

It is another preferred aspect that the polypropylene has an acid value of 1 or less. If this range of acid value is met, reduction of insulation reliability by addition of the polypropylene can be prevented.

In addition, it is another preferred aspect that the polypropylene has a glass transition temperature of 0°C or lower. If this range of glass transition temperature is met, deterioration of the clacking resistance of flux residues, which is required particularly for a paste for an on-vehicle electronic component, can be suppressed.

As described above, not only a flux for a solder paste including only one of the high-density polyethylene and the polypropylene, but also a flux for a solder paste including both thereof is one preferred aspect. If the solder paste including both the high-density polyethylene and the polypropylene meets the preferred ranges described above, the effects described above can be exhibited.

Incidentally, it is other preferred aspects that the solder pastes further include a waxy product having a melting point of 100°C or higher and being obtained by dehydration reaction of a higher aliphatic monocarboxylic acid, a polycarboxylic acid and diamine. This waxy product can help the action of the high-density polyethylene or polypropylene described above.

Employment of this solder paste improves the activity of a dibasic acid with a molecular weight of 250 or less. Therefore, good soldering ability is ensured. A monobasic acid with a molecular weight of 150 or greater and 300 or less and a dibasic acid with a molecular weight of 300 or greater and 600 or less, which are used in combination, promote the activation effect. In addition, the monobasic acid and dibasic acid used in combination with the dibasic acid with a molecular weight of 250 or less can cause a metal salt of a low-molecular weight dibasic acid to be uniformly dispersed in residues of the flux and to be enclosed by a hydrophobic base resin such as a rosin or an acrylic resin. Here, the metal salt of a low-molecular weight dibasic acid is a metal salt which is generated during soldering and has low solubility in flux residues. Therefore, not only decomposition and ionization of an organic acid metal salt in residues by water can be considerably suppressed, but also ionization of a remaining organic acid can be suppressed. As a result, there is obtained a flux which can further suppress electric insulation failures and occurrence of corrosion. In addition, a solder paste including such a flux has good soldering ability as well as high reliability.

In addition, for a resin included in the flux of a solder paste in this embodiment, a resin excellent in flexibility as represented by an acrylic resin can be applied from the viewpoint of improvement of the clacking resistance of residues. However, it is further one preferred aspect that any one or both of a rosin that has been conventionally used and a derivative thereof are additionally added. When any one or both of a rosin and a derivative thereof are used, the amount of any one or both of a rosin and a derivative thereof to be used is not particularly limited. However, it is preferable that any one or both of a rosin and a derivative thereof be present in an amount of 10 parts by weight or greater and 50 parts by weight or less based on 100 parts by weight of the flux from the viewpoints of soldering ability, corrosion resistance, printing workability and the like. From the aforementioned viewpoints, it is further preferable that any one or both of a rosin and a derivative thereof be present in an amount of 15 parts by weight or greater and 30 parts by weight or less based on 100 parts by weight of the flux.

Representative examples of the rosins described above are normal gum rosins, tall oil rosins and wood rosins. Representative examples of the derivatives of the rosin are heat-treated resins, polymerized rosins, hydrogenated rosins, formylated rosins, rosin esters, rosin modified maleic acid resins, rosin modified phenolic resins, acrylic acid addition rosins, rosin modified alkyd resins or the like. Such rosins and derivatives thereof are used as binders for uniformly coating an activator on a metal.

Further, a representative example of the acrylic resin described above is a thermoplastic acrylic resin prepared by polymerizing a monomer having polymerizable unsaturated groups by radical polymerization. Here, representative examples of the monomer having polymerizable unsaturated groups are (meth)acrylic acid, various kinds of esters thereof, crotonic acid, itaconic acid, maleic acid (anhydride) and esters thereof, (meth)acrylonitrile, (meth)acrylamide, vinyl chloride and vinyl acetate. Representative radical polymerizations are a bulk polymerization process, a liquid polymerization process, a suspension polymerization process and an emulsion polymerization process using such as a peroxide as a catalyst, but other known polymerization processes can be applied. It is a further preferred aspect that the acrylic resin has a weight average molecular weight of 6000 or greater and 12000 or less and a number average molecular weight of 4000 or greater and 6000 or less for providing excellent cracking resistance and flexibility.

One preferred example of the solvent used in this embodiment is a polar solvent that easily dissolves components such as an activator and a resin to form a solution. Typically, an alcohol solvent is used and particularly, diethylene glycol monoethers are excellent in volatility and activator solubility. When the aforementioned solvent is used, the amount of the solvent to be used is not particularly limited. However, it is preferable that the solvent be present in an amount of 15 parts by weight or greater and 40 parts by weight or less based on 100 parts by weight of the flux from the viewpoints of printing workability and stability of a paste. However, when multiple solvents are used in combination, the total amount of those solvents preferably falls within the range described above. From the aforementioned viewpoints, it is further preferable that the solvent be present in an amount of 20 parts by weight or greater and 35 parts by weight or less.

In production of the solder paste of this embodiment, a solvent may be used as required. The type of the solvent is not particularly limited. However, employment of a solvent with a boiling point of 150°C or higher is preferable in that the solvent is hard to be vaporized during production of the solder paste. Specific examples thereof include triethylene glycol monomethyl ether, triethylene glycol dimethyl ether, tetraethylene glycol dimethyl ether, diethylene glycol monomethyl ether, diethylene glycol monobutyl ether, diethylene glycol monohexyl ether, ethylene glycol monophenyl ether, diethylene glycol monophenyl ether, diethylene glycol monobutyl acetate, dipropylene glycol, diethylene glycol-2-ethyl-hexyl ether, $\alpha$-terpineol, benzyl alcohol, 2-hexyl decanol, butyl benzoate, diethyl adipate, diethyl phthalate, dodecane, tetradecene, dodecyl benzene, ethylene glycol, diethylene glycol, dipropylene glycol, triethylene glycol, hexylene glycol, 1,5-pentanediol, methyl carbitol and butyl carbitol. Preferably, examples of the solvent include triethylene glycol dimethyl ether, tetraethylene glycol dimethyl ether and diethylene glycol monobutyl acetate.

A method for producing a flux that is used for the solder paste of this embodiment will now be described.

First, the flux of this embodiment is obtained by dissolving or mixing the above-mentioned components by a known method. For example, first, the above-mentioned components are heated at once or sequentially to be dissolved and/or mixed, and are thereafter cooled. Subsequently, a physical impulsive force is applied through a mechanical grinding process, an impulsive deformation/fracture process or the like. The physical impulsive force may be applied to any one or both of the high-density polyethylene and the polypropylene before the dissolution process. The flux of this embodiment is obtained by mixing the components by the method described above. Specifically, a known device such as a kneading device, a vacuum mixer, a homo dispenser, a Three-One motor, a planetary mixer or the like can be used as a device for mixing the above-mentioned components. Here, the temperature for mixing the above-mentioned components is not particularly limited. However, it is one preferred aspect that the above-mentioned components are dissolved by heating at temperature lower than the boiling point of a solvent used in mixing.

A method for producing the solder paste of this embodiment will now be described.

First, the composition of a solder powder used for the solder paste of this embodiment is not particularly limited.

Specifically, one example thereof includes a solder powder containing one or more selected from the group consisting of tin (Sn), copper (Cu), zinc (Zn), silver (Ag), antimony (Sb), lead (Pb), indium (In), bismuth (Bi), nickel (Ni), aluminum (Al), gold (Au) and germanium (Ge). Another example includes a solder powder containing one or more selected from the group consisting of a known tin/lead alloy, a tin/silver alloy, a tin/silver/copper alloy, tin/silver/bismuth/indium, a tin/copper alloy, tin/copper/nickel, a tin/zinc alloy, a tin/zinc/bismuth alloy, a tin/zinc/aluminum alloy, a tin/zinc/bismuth/aluminum alloy, a tin/zinc/bismuth/indium alloy, a tin/bismuth alloy and a tin/indium alloy.

The shape of the solder powder is preferably spherical or substantially spherical. The solder powder can be mixed with the flux as long as its particle size is a normal size. For example, when a spherical solder powder is employed, employment of a solder powder with a diameter of 5 $\mu$m or larger and 60 $\mu$m or smaller is preferable from the viewpoint of increasing the accuracy of mounting of microelectronic components. The composition ratio of components constituting the solder powder is not particularly limited. For example, one preferred example of the solder powder includes Sn 63/Pb 37, Sn 96.5/Ag 3.5, Sn 96/Ag 3.5/Cu 0.5, Sn 96.6/Ag 2.9/Cu 0.5, Sn 96.5/Ag 3.0/Cu 0.5, Sn 42/Bi 58, Sn 99.3/Cu 0.7, Sn 91/Zn 9, or Sn 89/Zn 8/Bi 3. The values described above refer to the weight ratio of each metal.

The solder paste of this embodiment can be produced by blending the flux and the solder powder by known means. Specifically, a known device such as a vacuum mixer, a kneading device, a planetary mixer or the like can be used as a device for blending the above-mentioned components. Here, the treatment temperature and conditions for blending are not particularly limited. However, it is preferable that the treatment be carried out at 5°C or higher and 50°C or lower from the viewpoints of absorption of water from an external environment, oxidation of solder metal particles, thermal degradation of the flux due to temperature rising and the like. The weight ratio of the flux and the solder powder is not particularly limited. However, it is preferable that the weight ratio of the flux be 5 or greater and 20 or less while the weight ratio of the solder powder be 80 or greater and 95 or less from the viewpoints of printing workability and stability of a paste.

One or more materials selected from the group consisting of an antioxidant, a delustering agent, a colorant, a defoaming agent, a dispersion stabilizer, a chelating agent and the like can be further appropriately blended in the solder paste of this embodiment as necessary within the range of not impairing the effect of this embodiment.

Incidentally, the molar weight of viscosity of the polyethylene or the polypropylene in this application is a molar weight of viscosity Mv measured by a method of viscosity using an improved Ubbelohde viscometer. A specific method for measurement of a molar weight of viscosity is as follows.

First, decalin is added to a measurement sample, and the mixture is dissolved with shaking at 140°C for 30 minutes. The flow time (seconds) of the heated/dissolved sample solution at 135±0.2°C is measured by a viscometer to thereby obtain an intrinsic viscosity ([$\eta$]). The molar weight of viscosity is then calculated by substituting the measured value for [$\eta$] in the following formula for each of the polyethylene and the polypropylene.

[Mathematical Formula 1]

$$\text{Molar weight of viscosity of polyethylene} = 2.51 \times 10^4 \times 1.235 \, [\eta]$$

[Mathematical Formula 2]

$$\text{Molar weight of viscosity of polypropylene} = 10 \times 10^5 \times 1.25 \, [\eta]$$

The above embodiments will be described further in detail below by way of examples.

[Examples 1 and 2 and Comparative Example 1]

In Examples 1 and 2 and Comparative Example 1, solder pastes containing high-density polyethylenes are produced by the production method disclosed in the above embodiment. Table 1 shows the compositions of the solder pastes of Examples 1 and 2 and Comparative Example 1 and their composition ratios. Here, the high-density polyethylenes used in solder pastes of Examples 1 and 2 and Comparative Example 1 have an average of the longest particle sizes of about 35 $\mu$m, a molar weight of viscosity of about 2000, a melting point of 120°C, an acid value of 0, a glass transition temperature of -120°C and a density of 970 kg/m$^3$. Fig. 2 is a graph showing particle size distributions of high-density polyethylenes used in Examples 1 and 2 and Comparative Example 1.

An acrylic resin A contained in solder pastes of Examples 1 to 6 and Comparative Examples 1 to 3 has, as physical properties, a weight average molecular weight of about 9000, a number average molecular weight of 5000, an acid value of 0 and a glass transition temperature of -60°C. A polymerized rosin A contained in the solder pastes of Examples 1 to 6 and Comparative Examples 1 to 3 has a softening point of 140°C and an acid value of 145. Solder powders of Example 1 and Comparative Example 1 have 96.5% by weight of tin, 3.0% by weight of silver and 0.5% by weight of copper. In addition, the solder powder of Example 1 has a particle size distribution of 25 $\mu$m or greater and 38 $\mu$m or less. Solder powders used in Examples 2 to 6 and Comparative Examples 1 to 3 are the same as in Example 1, and therefore descriptions of those solder pastes can be omitted.

[Examples 3 and 4]

Solder pastes of Examples 3 and 4 are produced in the same manner as in Example 1. Table 1 also shows the compositions of the solder pastes of Examples 3 and 4 and their composition ratios. The high-density polyethylene used for the solder paste of Example 3 has an average of the longest particle sizes of about 5 $\mu$m, and the high-density polyethylene used for the solder paste of Example 4 has an average of the longest particle sizes of about 45 $\mu$m. The physical properties of the high-density polyethylenes are the same as those in Example 1 except for the average of the longest particle sizes. Therefore, duplicate descriptions are omitted.

[Example 5]

A solder paste of Example 5 is produced in the same manner as in Example 1. Table 1 also shows the composition of the solder paste of Example 5 and its composition ratio. The high-density polyethylene used in the solder paste of Example 5 has a molar weight of viscosity of about 4000, a melting point of 130°C, a glass transition temperature of -100°C and a density of 980 kg/m$^3$. The physical properties of the high-density polyethylene are same as those in Example 1 except for the molar weight of viscosity, the melting point, the glass transition temperature and the density. Therefore, duplicate descriptions are omitted.

[Example 6]

A solder paste of Example 6 is produced in the same manner as in Example 1. Table 1 also shows the composition of the solder paste of Example 6 and its composition ratio. The solder paste of Example 6 contains 0.1% by weight of a waxy product (product name: Light Amide WH-255, manufactured by KYOEISHA CHEMICAL Co., LTD.) in addition to the composition in Example 5. The physical properties of the high-density polyethylene are all the same as those in Example 5. Therefore, duplicate descriptions are omitted.

[Comparative Examples 2 and 3]

Solder pastes of Comparative Examples 2 and 3 are produced in the same manner as in Example 1. Table 1 also shows the compositions of the solder pastes of Comparative Examples 2 and 3 and their composition ratios. The low-density polyethylene used in the solder paste of Comparative Example 2 has an average of the longest particle sizes of about 40 $\mu$m, a molar weight of viscosity of about 2500, a melting point of 105°C, an acid value of 0, and a glass transition temperature of -110°C. The low-density polyethylene used in the solder paste of Comparative Example 3 has an average of the longest particle sizes of about 38 $\mu$m, a molar weight of viscosity of about 4500, a melting point of 105°C, an acid value of 0, and a glass transition temperature of -100°C. The densities of low-density polyethylene A of Comparative Example 2 and low-density polyethylene B of Comparative Example 3 are both 920 kg/m$^3$.

[Table 1]

| Composition | Example 1 weight (%) | Example 2 weight (%) | Example 3 weight (%) | Example 4 weight (%) | Example 5 weight (%) | Example 6 weight (%) | Comparative Example 1 weight (%) | Comparative Example 2 weight (%) | Comparative Example 3 weight (%) |
|---|---|---|---|---|---|---|---|---|---|
| acrylic resin A | 2.4 | 2.6 | 2.5 | 2.5 | 2.5 | 2.4 | 2.7 | 2.5 | 2.5 |
| Polymerized rosin (*1) | 2.2 | 2.4 | 2.3 | 2.3 | 2.3 | 2.3 | 2.6 | 2.3 | 2.3 |
| Suberic acid | 0.3 | 0.3 | 0.3 | 0.3 | 0.3 | 0.3 | 0.3 | 0.3 | 0.3 |
| Dibromosalicylic acid | 0.5 | 0.5 | 0.5 | 0.5 | 0.5 | 0.5 | 0.5 | 0.5 | 0.5 |
| Diethylene glycol monohexyl ether | 3.15 | 3.15 | 3.15 | 3.15 | 3.15 | 3.15 | 3.15 | 3.15 | 3.15 |
| Unsaturated fatty acid acrylic acid adduct (*2) | 0.3 | 0.3 | 0.3 | 0.3 | 0.3 | 0.3 | 0.3 | 0.3 | 0.3 |
| Diphenylguanidine hydrobromide | 0.05 | 0.05 | 0.05 | 0.05 | 0.05 | 0.05 | 0.05 | 0.05 | 0.05 |
| Ethylenebis 12 hydroxystearic acid amide | 0.2 | 0.2 | 0.2 | 0.2 | 0.2 | 0.2 | 0.2 | 0.2 | 0.2 |
| High-density polyethylene A | 0.9 | 0.5 | 0.7 | 0.7 | | | | 0.2 | |
| High-density polyethylene B | | | | | 0.7 | 0.7 | | | |
| Low-density polyethylene A | | | | | | | | 0.7 | |
| Low-density polyethylene B | | | | | | | | | 0.7 |
| Waxy product | | | | | | 0.1 | | | |
| Solder powder | 90 | 90 | 90 | 90 | 90 | 90 | 90 | 90 | 90 |
| Total | 100.0 | 100.0 | 100.0 | 100.0 | 100.0 | 100.0 | 100.0 | 100.0 | 100.0 |

(continued)

| Composition | Example 1 weight (%) | Example 2 weight (%) | Example 3 weight (%) | Example 4 weight (%) | Example 5 weight (%) | Example 6 weight (%) | Comparative Example 1 weight (%) | Comparative Example 2 weight (%) | Comparative Example 3 weight (%) |
|---|---|---|---|---|---|---|---|---|---|
| Particle size of polyethylene (μm) | 35 | 35 | 5 | 45 | 35 | 35 | 35 | 40 | 38 |

*1: Manufacturer (Arakawa Chemical Industries, Ltd.)
*2: Product name, manufacturer (DIACID 1550, Harima Chemicals, Inc.)

**EP 2 524 763 B1**

[Examples 7 and 8 and Comparative Examples 4 to 6]

In Examples 7 and 8, solder pastes containing polypropylene A are produced by the production method disclosed in the above embodiment. Table 2 shows the compositions of the solder pastes of Examples 7 and 8 and their composition ratios. As comparative examples, compositions of Comparative Examples 4 to 6 and their composition ratios are shown in Table 2. Solder pastes of Comparative Examples 4 to 6 are also produced by the production method disclosed in the above embodiment. Here, the polypropylene A used in the solder pastes of Examples 7 and 8 has an average of the longest particle sizes of about 30 $\mu$m, a molar weight of viscosity of about 10000, a melting point of 145°C, an acid value of 0 and a glass transition temperature of -20°C. A hardened castor oil is mixed in the solder paste of Comparative Example 4 in place of polypropylenes A and B. In addition, medium-density polyethylene A with an average of the longest particle sizes of about 33 $\mu$m, a molar weight of viscosity of about 2700, a melting point of 110°C, an acid value of 30, a glass transition temperature of about -80°C and a density of 930 kg/m$^3$ is mixed in the solder paste of Comparative Example 5 in place of polypropylenes A and B. Further, the solder paste of Comparative Example 6 does not contain polypropylenes A and B, but contains 0.9% by weight of hexamethylenebis 12 hydroxystearic acid amide.

An acrylic resin B contained in solder pastes of Examples 7 to 13 and Comparative Examples 4 to 6 has, as physical properties, a weight average molecular weight of about 9000, a number average molecular weight of about 5000, an acid value of 3 and a glass transition temperature of -55°C. A hydrogenated rosin contained in the solder pastes of Examples 7 to 13 has a softening point of 81°C and an acid value of 165. Solder powder of Example 7 is same as the solder paste of Example 1. Solder powders of Examples 8 to 13 and Comparative Examples 4 to 6 are the same as that in Example 11, and therefore descriptions of those solder powders are omitted.

[Examples 9 and 10]

The solder pastes of Examples 9 and 10 are also produced in the same manner as in Example 7. Table 2 also shows the compositions of the solder pastes of Examples 9 and 10 and their composition ratios. Polypropylene A used in the solder paste of Example 9 has an average of the longest particle sizes of about 8 $\mu$m, and polypropylene A used in the solder paste of Example 10 has an average of the longest particle sizes of about 42 $\mu$m. The physical properties of the polypropylene are all the same as those in Example 7 except for the average of the longest particle sizes. Therefore, duplicate descriptions are omitted.

[Example 11]

A solder paste of Example 11 is also produced in the same manner as in Example 7. Table 2 also shows the composition of the solder paste of Example 11 and its composition ratio. Polypropylene B used in the solder paste of Example 11 has an average of the longest particle sizes of about 20 $\mu$m, a molar weight of viscosity of about 19000, a melting point of 147°C, an acid value of 0 and a glass transition temperature of -25°C.

[Example 12]

A solder paste of Example 12 is also produced in the same manner as in Example 7. Table 2 also shows the composition of the solder paste of Example 12 and its composition ratio. The solder paste of Example 12 contains 0.1% by weight of a waxy product (product name: Light Amide WH-255 manufactured by KYOEISHA CHEMICAL Co., LTD.) in addition to the composition in Example 11. The physical properties of polypropylene B are all the same as those in Example 11. Therefore, duplicate descriptions can be omitted.

[Example 13]

A solder paste of Example 13 is also produced in the same manner as in Example 7. Table 2 also shows the composition of the solder paste of Example 13 and its composition ratio. The solder paste of Example 13 contains 0.4% by weight of each of the high-density polyethylene A used in Example 1 and the polypropylene A used in Example 7.

[Table 2]

| Composition | Example 7 weight (%) | Example 8 weight (%) | Example 9 weight (%) | Example 10 weight (%) | Example 11 weight (%) | Example 12 weight (%) | Example 13 weight (%) | Comparative Example 4 weight (%) | Comparative Example 5 weight (%) | Comparative Example 6 weight (%) |
|---|---|---|---|---|---|---|---|---|---|---|
| Acrylic resin B | 2.4 | 2.6 | 2.5 | 2.5 | 2.5 | 2.4 | 2.4 | 2.5 | 2.5 | 2.5 |
| Hydrogenated rosin (*3) | 2.2 | 2.4 | 2.3 | 2.3 | 2.3 | 2.3 | 2.3 | 2.3 | 2.3 | 2.3 |
| Adipic acid | 0.3 | 0.3 | 0.3 | 0.3 | 0.3 | 0.3 | 0.3 | 0.3 | 0.3 | 0.3 |
| Diphenylacetic acid | 0.5 | 0.5 | 0.5 | 0.5 | 0.5 | 0.5 | 0.5 | 0.5 | 0.5 | 0.5 |
| Diethylene glycol monohexyl ether | 3.15 | 3.15 | 3.15 | 3.15 | 3.15 | 3.15 | 3.15 | 3.15 | 3.15 | 3.15 |
| Unsaturated fatty acid dimer (*4) | 0.3 | 0.3 | 0.3 | 0.3 | 0.3 | 0.3 | 0.3 | 0.3 | 0.3 | 0.3 |
| Diphenylguanidin e hydrobromide | 0.05 | 0.05 | 0.05 | 0.05 | 0.05 | 0.05 | 0.05 | 0.05 | 0.05 | 0.05 |
| Hexamethylenebis 12 hydroxystearic acid amide | 0.2 | 0.2 | 0.2 | 0.2 | 0.2 | 0.2 | 0.2 | 0.2 | 0.2 | 0.9 |
| Polypropylene A | 0.9 | 0.5 | 0.7 | 0.7 | | | 0.4 | | | |
| Polypropylene B | | | | | 0.7 | 0.7 | | | | |
| High-density polyethylene A | | | | | | | 0.4 | | | |
| Medium-density polyethylene A | | | | | | | | | 0.7 | |
| Hardened castor oil | | | | | | | | 0.7 | | |
| Waxy product | | | | | | 0.1 | | | | |
| Solder powder | 90 | 90 | 90 | 90 | 90 | 90 | 90 | 90 | 90 | 90 |
| Total | 100.0 | 100.0 | 100.0 | 100.0 | 100.0 | 100.0 | 100.0 | 100.0 | 100.0 | 100.0 |

(continued)

| Composition | Example 7 weight (%) | Example 8 weight (%) | Example 9 weight (%) | Example 10 weight (%) | Example 11 weight (%) | Example 12 weight (%) | Example 13 weight (%) | Comparative Example 4 weight (%) | Comparative Example 5 weight (%) | Comparative Example 6 weight (%) |
|---|---|---|---|---|---|---|---|---|---|---|
| Polyethylene polypropylene particle size (μm) | 30 | 30 | 8 | 42 | 20 | 20 | PE35 PP30 | 30 | 33 | 30 |

*3: Manufacturer (Eastman Chemical Company)
*4: Product name, manufacturer (HARIDIMER 250, Harima Chemicals, Inc.)

As a result of analyzing the solder pastes of Examples 1 to 13 and the solder pastes of Comparative Examples 1 to 6, it was found that the solder pastes of Examples 1 to 13 each contributed to an improvement in slumping resistance as shown in Table 3. The solder pastes of Examples 1 to 13 each had a viscosity of 400 Pa●s or greater at 80°C. Since the solder paste had a high viscosity during heating, good results were obtained even in a slump test using a solder paste after continuous printing for 4 hours. Further, the solder pastes of Examples 1 to 13 described above also maintained high insulation resistance values. In table 3, the unit of the "slump" is mm and the unit of the "insulation resistance" value is Ω.

[Table 3]

| | Example 1 | Example 2 | Example 3 | Example 4 | Example 5 | Example 6 | Example 7 | Example 8 | Example 9 | Example 10 |
|---|---|---|---|---|---|---|---|---|---|---|
| Paste viscosity at 80°C (Pa●s) | 2500 | 650 | 2000 | 2000 | 2300 | 700 | 630 | 540 | 590 | 590 |
| Slump after continuous printing for 4 hours | 0.2 | 0.3 | 0.2 | 0.2 | 0.2 | 0.2 | 0.3 | 0.4 | 0.3 | 0.3 |
| Minimum value of insulation resistance (beginning to 168 hours) | 5.0E+09 | 2.0E+09 | 4.5E+09 | 4.5E+09 | 5.0E+09 | 5.2E+09 | 4.5E+09 | 2.5E+09 | 4.1E+09 | 4.1E+09 |

| | Example 11 | Example 12 | Example 13 | Comparative Example 1 | Comparative Example 2 | Comparative Example 3 | Comparative Example 4 | Comparative Example 5 | Comparative Example 6 |
|---|---|---|---|---|---|---|---|---|---|
| Paste viscosity at 80°C (Pa●s) | 730 | 700 | 630 | 360 | 1200 | 1800 | 360 | 1200 | 350 |
| Slump after continuous printing for 4 hours | 0.2 | 0.2 | 0.2 | 0.5 | 0.2 | 0.2 | 0.6 | 0.2 | 0.5 |
| Minimum value of insulation resistance (beginning to 168 hours) | 4.3E+09 | 5.0E+09 | 5.4E+09 | 2.0E+09 | 3.0E+08 | 6.0E+08 | 2.5E+09 | 3.0E+08 | 1.0E+09 |

On the other hand, it was found that the solder paste of each of Comparative Examples 1, 4 and 6 at 80°C had a viscosity of 400 Pa●s or less, and its slump was inferior as compared to the examples described above. It was found that the solder paste of each of Comparative Examples 2, 3 and 5 at 80°C had a viscosity of 400 Pa●s or greater, but its insulation characteristic was inferior to that of the examples described above.

Measurements of the viscosity of the solder paste in this application were made using a viscoelasticity measuring device. The specific procedure is as follows:

(1) a solder paste as a sample is inserted between a sample stage of a measuring device and a stainless parallel flat plate of a measurement jig with a diameter of 25 mm,
(2) the gap between the sample stage and the parallel flat plate is set to 1.0 mm, and
(3) distortion is created at a frequency of 5 Hz and a swing angle of 0.1% to measure the viscosity at 80°C.

The embodiment and the examples described above are not intended to limit the present invention. Modifications within the scope of the invention including other combinations of the embodiment and the examples described above also fall within the claims.

INDUSTRIAL APPLICABILITY

The solder paste of the present invention is very useful for solder bonding in various applications such as electronic circuit components.

**Claims**

1. A solder paste comprising, within a flux, an activator that has a dibasic acid with a molecular weight of 250 or less, a monobasic acid with a molecular weight of 150 or greater and 300 or less, and a dibasic acid with a molecular weight of 300 or greater and 600 or less; and at least one resin additive selected from the group consisting of polyethylenes having a density of 942 kg/m$^3$ or greater and polypropylenes, wherein the solder paste has the resin additive in an amount of 4% by weight or greater and 12% by weight or less when the total amount of the flux is taken as 100% by weight, and the solder paste has a viscosity, when measured according to the method and with the means for measurement as described in paragraph [0067] of the description, of 400 Pa·s or greater at 80°C,

   wherein the dibasic acid with a molecular weight of 250 or less is selected from the group of malonic acid, succinic acid, glutaric acid, adipic acid, suberic acid, sebacic acid, phthalic acid, hexahydrophthalic acid, aminosuccinic acid and diphenic acid,
   wherein the monobasic acid with a molecular weight of 150 or greater and 300 or less is selected from the group of decanoic acid, stearic acid, oleic acid, anisic acid, benzoylbenzoic acid, dichlorobenzoic acid, dibromosalicylic acid, diphenyl acetic acid and cuminic acid, and
   wherein the dibasic acid with a molecular weight of 300 or greater and 600 or less is selected from the group of an esterification product of diethylene glycol and succinic anhydride, a (meth)acrylic acid adduct of an unsaturated fatty acid and a dimer of an unsaturated fatty acid.

2. The solder paste according to claim 1, wherein the particulate polyethylenes within the flux for a solder paste meet at least one of the following requirements a) to d):

   a) the polyethylenes have an average of the longest particle sizes of 0.001 $\mu$m or greater and 50 $\mu$m or less;
   b) the number of polyethylenes with a longest particle size of 60 $\mu$m or less within a randomly selected field of 1.5 mm x 1.1 mm in the flux for a solder paste is 90% or greater of the total number of the polyethylenes when observed at a 200x magnification by a light microscope;
   c) the number of polyethylenes with a longest particle size of 100 $\mu$m or greater within a randomly selected field of 3.1 mm x 2.3 mm in the flux for a solder paste is 1% or less of the total number of the polyethylenes when observed at a 100x magnification by a light microscope; and
   d) the polyethylene has a polyhedron shape.

3. The solder paste according to claim 1 or 2, wherein the polyethylene has a molar weight of viscosity of 1500 or greater and 4500 or less.

4. The solder paste according to claim 1 or 2, wherein the polyethylene has a melting point of 110°C or higher and 130°C or lower.

5. The solder paste according to claim 1 or 2, wherein the polyethylene has an acid value of 1 or less.

6. The solder paste according to claim 1 or 2, wherein the polyethylene has a glass transition temperature of -50°C or lower.

7. The solder paste according to claim 1, wherein the particulate polypropylenes within the flux for a solder paste meet at least one of the following requirements a) to d):

   a) the polypropylene has an average of the longest particle sizes of 0.001 $\mu$m or greater and 50 $\mu$m or less;
   b) the number of polypropylene with a longest particle size of 60 $\mu$m or less within a randomly selected field of 1.5 mm x 1.1 mm in the flux for a solder paste is 90% or greater of the total number of the polypropylene when observed at a 200x magnification by a light microscope;
   c) the number of polypropylene with a longest particle size of 100 $\mu$m or greater within a randomly selected field of 3.1 mm x 2.3 mm in the flux for a solder paste is 1% or less of the total number of the polypropylene when observed at a 100x magnification by a light microscope; and
   d) the polypropylene has a polyhedron shape.

8. The solder paste according to claim 1 or 7, wherein the polypropylene has a molar weight of viscosity of 5000 or greater and 20000 or less.

**9.** The solder paste according to claim 1 or 7, wherein the polypropylene has a melting point of 130°C or higher and 160°C or less.

**10.** The solder paste according to claim 1 or 7, wherein the polypropylene has an acid value of 1 or less.

**11.** The solder paste according to claim 1 or 7, wherein the polypropylene has a glass transition temperature of 0°C or lower.

**12.** The solder paste according to any of claims 1, 2 and 7, further comprising a waxy product obtained by dehydration reaction of a higher aliphatic monocarboxylic acid, a polycarboxylic acid and diamine.

**13.** The solder paste according to claim 12, wherein the waxy product has a melting point of 100°C or higher.

**Patentansprüche**

**1.** Lötpaste, welche in einem Flussmittel einen Aktivator, der eine dibasische Säure mit einem Molekulargewicht von 250 oder weniger, eine monobasische Säure mit einem Molekulargewicht von 150 oder mehr und 300 oder weniger und eine dibasische Säure mit einem Molekulargewicht von 300 oder mehr und 600 oder weniger enthält; und mindestens einen Harzzusatz ausgewählt aus der Gruppe bestehend aus Polyethylenen mit einer Dichte von 942 kg/m$^3$ oder mehr und Polypropylenen umfasst, wobei die Lötpaste den Harzzusatz in einer Menge von 4 Gewichts% oder mehr und 12 Gewichts% oder weniger aufweist, wenn die Gesamtmenge an Flussmittel als 100 Gewichts% genommen wird, und die Lötpaste eine Viskosität gemessen gemäß dem Verfahren und mit den Mitteln für Messung wie in Absatz [0067] der Beschreibung beschrieben von 400 Pa·s oder mehr bei 80°C aufweist,

wobei die dibasische Säure mit einem Molekulargewicht von 250 oder weniger ausgewählt ist aus der Gruppe von Malonsäure, Bernsteinsäure, Glutarsäure, Adipinsäure, Korksäure, Sebazinsäure, Phthalsäure, Hexahydrophthalsäure, Asparaginsäure und Diphensäure,
wobei die monobasische Säure mit einem Molekulargewicht von 150 oder mehr und 300 oder weniger ausgewählt ist aus der Gruppe von Decansäure, Stearinsäure, Ölsäure, Anissäure, Benzylbenzoesäure, Dichlorobenzoesäure, Dibromosalicylsäure, Diphenylessigsäure und Cuminsäure, und
wobei die dibasische Säure mit einem Molekulargewicht von 300 oder mehr und 600 oder weniger ausgewählt ist aus der Gruppe von einem Veresterungsprodukt aus Diethylenglykol und Bernsteinsäureanhydrid, einem (Meth)acrylsäure-Addukt einer ungesättigten Fettsäure und einem Dimer einer ungesättigten Fettsäure.

**2.** Lötpaste nach Anspruch 1, wobei die partikelförmigen Polyethylene in dem Flussmittel für eine Lötpaste mindestens eine der folgenden Bedingungen a) bis d) erfüllen:

a) die Polyethylene weisen ein Mittel der längsten Partikelgrößen von 0,001 μm oder mehr und 50 μm oder weniger auf;
b) die Anzahl der Polyethylene mit einer längsten Partikelgröße von 60 μm oder weniger innerhalb eines zufällig ausgewählten Feldes von 1,5 mm x 1,1 mm in dem Flussmittel für eine Lötpaste ist 90% oder mehr der Gesamtanzahl der Polyethylene betrachtet mit einer 200-fachen Vergrößerung durch einLichtmikroskop;
c) die Anzahl der Polyethylene mit einer längsten Partikelgröße von 100 μm oder mehr innerhalb eines zufällig ausgewählten Feldes von 3,1 mm x 2,3 mm in dem Flussmittel für eine Lötpaste ist 1% oder weniger der Gesamtanzahl der Polyethylene betrachtet mit einer 100-fachen Vergrößerung durch ein Lichtmikroskop; und
d) das Polyethylen weist eine Polyederform auf.

**3.** Lötpaste nach Anspruch 1 oder 2, wobei das Polyethylen ein durch die Viskosität bestimmtes Molgewicht von 1500 oder mehr und 4500 oder weniger aufweist.

**4.** Lötpaste nach Anspruch 1 oder 2, wobei das Polyethylen einen Schmelzpunkt von 110°C oder höher und 130°C oder niedriger aufweist.

**5.** Lötpaste nach Anspruch 1 oder 2, wobei das Polyethylen einen Säuregrad von 1 oder weniger aufweist.

**6.** Lötpaste nach Anspruch 1 oder 2, wobei das Polyethylen eine Glasumwandlungstemperatur von -50°C oder niedriger aufweist.

**7.** Lötpaste nach Anspruch 1, wobei die partikelförmigen Polypropylene in dem Flussmittel für eine Lötpaste mindestens eine der folgenden Bedingungen a) bis d) erfüllen:

a) das Polypropylen weist ein Mittel der längsten Partikelgrößen von 0,001 $\mu$m oder mehr und 50 $\mu$m oder weniger auf;
b) die Anzahl der Polypropylene mit einer längsten Parikelgröße von 60 $\mu$m oder weniger innerhalb eines zufällig ausgewählten Feldes von 1,5 mm x 1,1 mm in dem Flussmittel für eine Lötpaste ist 90% oder mehr der Gesamtanzahl der Polypropylene betrachtet mit einer 200-fachen Vergrößerung durch ein Lichtmikroskop;
c) die Anzahl der Polypropylene mit einer längsten Partikelgröße von 100 $\mu$m oder mehr innerhalb eines zufällig ausgewählten Feldes von 3,1 mm x 2.3 mm in dem Flussmittel für ein Lötpaste ist 1% oder weniger der Gesamtanzahl der Polypropylene betrachtet mit einer 100-fachen Vergrößerung durch ein Lichtmikroskop; und
d) das Polypropylen weist eine Polyederform auf.

**8.** Lötpaste nach Anspruch 1 oder 7, wobei das Polypropylen ein durch die Viskosität bestimmtes Molgewicht von 5000 oder mehr und 2000 oder weniger aufweist.

**9.** Lötpaste nach Anspruch 1 oder 7, wobei das Polypropylen einen Schmelzpunkt von 130°C oder höher und 160°C oder niedriger aufweist.

**10.** Lötpaste nach Anspruch 1 oder 7, wobei das Polypropylen einen Säuregrad von 1 oder weniger aufweist.

**11.** Lötpaste nach Anspruch 1 oder 7, wobei das Polypropylen eine Glasumwandlungstemperatur von 0°C oder niedriger aufweist.

**12.** Lötpaste nach einem der Ansprüche 1, 2 und 7, die ferner ein wachsartiges Produkt erhalten durch eine Dehydratisierungsreaktion einer höheren aliphatischen Monocarbonsäure, einer Polycarbonsäure und Diamin umfasst.

**13.** Lötpaste nach Anspruch 12, wobei das wachsartige Produkt eine Schmelztemperatur von 100°C oder höher aufweist.

## Revendications

**1.** Pâte à braser comprenant, dans un flux, un activateur qui comprend un acide dibasique ayant un poids moléculaire de 250 ou moins, un acide monobasique ayant un poids moléculaire de 150 ou plus et de 300 ou moins, et un acide dibasique ayant un poids moléculaire de 300 ou plus et de 600 ou moins ; et au moins un additif de résine choisi dans le groupe constitué de polyéthylènes ayant une densité de 942 kg/$m^3$ ou plus et de polypropylènes, dans laquelle la pâte à braser comporte l'additif de résine en une proportion de 4 % en poids ou plus et de 12 % en poids ou moins lorsque la quantité totale du flux est prise en tant que 100 % en poids, et la pâte à braser a une viscosité, lorsqu'elle est mesurée conformément au procédé et à l'aide des moyens de mesure tels que décrits au paragraphe [0067] de la description, de 400 Pa.s ou plus à 80°C,
dans laquelle l'acide dibasique ayant un poids moléculaire de 250 ou moins est choisi dans le groupe constitué de l'acide malonique, l'acide succinique, l'acide glutarique, l'acide adipique, l'acide subérique, l'acide sébacique, l'acide phtalique, l'acide hexahydrophtalique, l'acide aminosuccinique et l'acide diphénique,
dans laquelle l'acide monobasique ayant un poids moléculaire de 150 ou plus et de 300 ou moins est choisi dans le groupe constitué de l'acide décanoïque, l'acide stéarique, l'acide oléique, l'acide anisique, l'acide benzoylbenzoïque, l'acide dichlorobenzoïque, l'acide dibromosalicylique, l'acide diphénylacétique et l'acide cuminique, et
dans laquelle l'acide dibasique ayant un poids moléculaire de 300 ou plus et de 600 ou moins est choisi dans le groupe constitué d'un produit d'estérification de diéthylèneglycol et d'anhydride succinique, d'un produit d'addition d'acide (méth)acrylique d'un acide gras non saturé et un dimère d'un acide gras non saturé.

**2.** Pâte à braser selon la revendication 1, dans laquelle les polyéthylènes en particules contenus dans le flux pour pâte à braser respectent au moins l'une des conditions suivantes a) à d) :

a) les polyéthylènes ont une moyenne des tailles de particules les plus longues de 0,001 $\mu$m ou plus et de 50 $\mu$m ou moins ;
b) le nombre de polyéthylènes ayant une taille de particules les plus longues de 60 $\mu$m ou moins dans un domaine choisi au hasard de 1,5 mm x 1,1 mm dans le flux pour pâte à braser est de 90 % ou plus du nombre total des polyéthylènes lorsqu'on observe à un grossissement 200x au microscope optique ;

c) le nombre de polyéthylènes ayant une taille de particules les plus longues de 100 $\mu$m ou plus dans un domaine choisi au hasard de 3,1 mm x 2,3 mm dans le flux pour pâte à braser est de 1 % ou moins du nombre total des polyéthylènes lorsqu'on observe à un grossissement 100x au microscope optique ; et
d) les polyéthylènes ont une forme de polyèdre.

3. Pâte à braser selon la revendication 1 ou 2, dans laquelle le polyéthylène a une masse molaire basée sur la mesure de viscosité de 1500 ou plus et de 4500 ou moins.

4. Pâte à braser suivant la revendication 1 ou 2, dans laquelle le polyéthylène a un point de fusion de 110°C ou plus et de 130°C ou moins.

5. Pâte à braser suivant la revendication 1 ou 2, dans laquelle le polyéthylène a un indice d'acide de 1 ou moins.

6. Pâte à braser selon la revendication 1 ou 2, dans laquelle le polyéthylène a une température de transition vitreuse de -50°C ou moins.

7. Pâte à braser selon la revendication 1, dans laquelle les polypropylènes en particules contenus dans le flux pour pâte à braser respectent au moins l'une des conditions suivantes a) à d) :

   a) les polypropylènes ont une moyenne des tailles de particules les plus longues de 0,001 $\mu$m ou plus et de 50 $\mu$m ou moins ;
   b) le nombre de polypropylènes ayant une taille de particules les plus longues de 60 $\mu$m ou moins dans un domaine choisi au hasard de 1,5 mm x 1,1 mm dans le flux pour pâte à braser est de 90 % ou plus du nombre total des polypropylènes lorsqu'on observe à un grossissement 200x au microscope optique ;
   c) le nombre de polypropylènes ayant une taille de particules les plus longues de 100 $\mu$m ou plus dans un domaine choisi au hasard de 3,1 mm x 2,3 mm dans le flux pour pâte à braser est de 1 % ou moins du nombre total des polypropylènes lorsqu'on observe à un grossissement 100x au microscope optique ; et
   d) les polypropylènes ont une forme de polyèdre.

8. Pâte à braser selon la revendication 1 ou 7, dans laquelle le polypropylène a une masse molaire basée sur la mesure de viscosité de 5000 ou plus et de 20000 ou moins.

9. Pâte à braser suivant la revendication 1 ou 7, dans laquelle le polypropylène a un point de fusion de 130°C ou plus et de 160°C ou moins.

10. Pâte à braser suivant la revendication 1 ou 7, dans laquelle le polypropylène a un indice d'acide de 1 ou moins.

11. Pâte à braser selon la revendication 1 ou 7, dans laquelle le polypropylène a une température de transition vitreuse de 0°C ou moins.

12. Pâte à braser suivant l'une quelconque des revendications 1, 2 et 7, comprenant en outre un produit cireux obtenu par réaction de déshydratation d'un acide monocarboxylique aliphatique supérieur, un acide polycarboxylique et une diamine.

13. Pâte à braser suivant la revendication 12, dans laquelle le produit cireux a un point de fusion de 100°C ou plus.

[Fig. 1]

HIGH-DENSITY POLYETHYLENE

$\overline{75\mu \text{ m}}$

[Fig. 2]

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002336993 A
- JP H067989 B
- JP H0788675 B
- JP H09253884 B